# EUROPEAN PATENT APPLICATION

(11) **EP 1 364 788 A2**
(43) Date of publication of application: **26.11.2003**
(21) Application number: 02257528.6
(22) Date of filing: 30.10.2002
(51) Int. Cl.: B41J 2/14

(54) **Ink jet print head and method and apparatus for bonding flexible printed circuit cable for ink jet print head**

(30) Priority: 20.05.2002 KR 2002027867
(71) Applicant: SAMSUNG ELECTRONICS CO., LTD., Suwon-City, Kyungki-do (KR)
(72) Inventor: Kim, Jeong-seon, Paldal-gu, Suwon-si, Gyeonggi-do (KR); Cho, Seo-hyun, Bundang-gu, Seongnam-si, Gyeonggi-do (KR); Son, Dae-woo, Cheonan-si, Chungcheongnam-do (KR); Kang, Sa-yoon, Seoul (KR); Jung, Myung-song, Gyeonggi-do (KR)
(74) Representative: Brandon, Paul Laurence

(57) **Abstract**

An ink jet print head, a method of bonding a flexible printed circuit (FPC) (60) cable for an ink jet print head, and an apparatus adopting the method are provided. In this bonding method, the bonding portion of an FPC conductor (61) is heated being pressed down on a corresponding pad (20) formed on a substrate (10) for an ink jet print head. Then, at least two pads (20) are bonded at a time. In this bonding method, an electrical defect due to pad peel-off phenomenon, which is created by an conventional tape automated bonding (TAB) method in which the conductors of an FPC cable are bonded to the pads on a substrate in a manner where one conductor is bonded to a pad at a time, is removed to increase the reliability of bonding. In addition, the bonding of a plurality of pads (20) at a time leads to a reduction in the time required for bonding.

## Description

The present invention relates to ink jet print heads, methods of bonding a flexible printed circuit (FPC) cable for an ink jet print head, and to apparatus adopting the method.

In an ink jet head adopting an electro-thermal transducing technique for discharging ink droplet using bubbles obtained by instantaneously heating ink, a substrate having heaters and nozzles thereon is included. The substrate also includes a plurality of signal lines electrically connected to the heaters, and a plurality of electric pads arranged on the edge of the substrate in an inline configuration in order to achieve the contact of the signal lines and an external circuit.

The pads are connected to an FPC cable on which a plurality of conductors corresponding to the pads are arranged side by side. The pads are bonded to the conductors by thermosonic bonding.

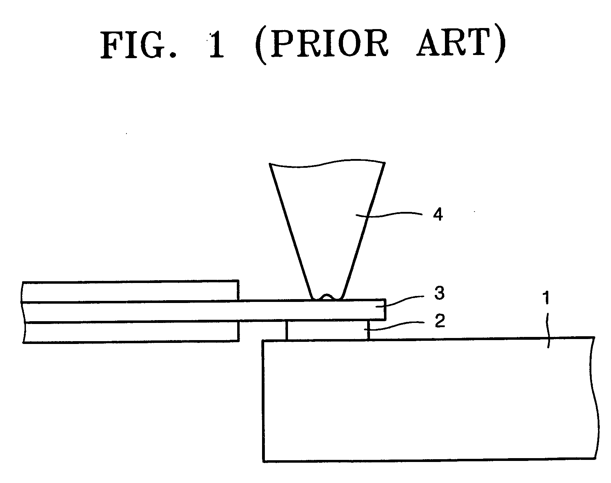

U.S. Patent Nos. US-A-4,635,073 and US-A-6,126,271 disclose a method of bonding pads to conductors using a thermosonic bonding technique. The thermosonic bonding technique corresponds to a single point bonding method of bonding a single point at a time. Accordingly, as shown in Figure 1, in a state where a conductor 3 contacts a pad 2 installed on a substrate 1 and then a thermosonic bonding tool 4 contacts the resultant substrate structure, the pad 2 is bonded to the conductor 3 by one time bonding. In this way, the other pads and conductors are sequentially bonded together. According to this conventional method, as many bonding processes as the number of pads installed on a substrate must be performed, consequently requiring a lot of time to bond an FPC cable to a single substrate.

In addition, the bonding tool partially contacts the conductor upon thermosonic bonding, and hence the contacted portion of the conductor on which vibration energy generated by ultrasonic is focused may be deformed. Accordingly, the rigidity of the contacted portion decreases, so that the conductor may be easily separated from the pad.

It is an aim of preferred embodiments of the present invention to provide an ink jet print head, a method of bonding a flexible printed circuit (FPC) cable for an ink jet print head, and an apparatus adopting the method, in which a reduction in the time for bonding conductors leads to a decrease in the time required for manufacturing an ink jet print head.

Another aim of preferred embodiments of the present invention is to provide an ink jet print head, a method of bonding an FPC cable for an ink jet print head, and an apparatus adopting the method, in which the portion where an FPC conductor and a pad are joined together provides an increased structural intensity.

Still another aim of preferred embodiments of the present invention is to provide an ink jet print head, a method of bonding an FPC cable for an ink jet print head, and an apparatus adopting the method, in which the printing quality is increased by a reduction in the interlaced distance of droplet.

The present invention provides, in a first aspect, a method of bonding an FPC for an ink jet print head, the method comprising: preparing a substrate for an ink jet print head, the substrate having a plurality of resistive heaters, a plurality of signal lines connected to the resistive heaters, and a plurality of electrical pads for connecting the signal lines to the outside; preparing an FPC cable having a plurality of conductors having bonding portions, the conductors corresponding to the pads; preparing a bonding apparatus adopting a hot pressure welding technique, the bonding apparatus having a stage for mounting the substrate on and a bonding tool for pressing the bonding portions of the conductors down on the pads of the substrate and heating the bonding portions attached to the pads; mounting the substrate on the stage of the bonding apparatus in order to combine the substrate with the FPC cable; arranging the FPC cable on the substrate so that the bonding portions of the conductors face the corresponding pads; and pressing at least two conductors down on the corresponding pads at a time using the bonding tool and heating the conductors using the bonding tool, to thereby bond the conductors to the pads.

The present invention provides, in a second aspect, another method of bonding an FPC for an ink jet print head, the method comprising: preparing a substrate for an ink jet print head, the substrate having a plurality of resistive heaters, a plurality of signal lines connected to the resistive heaters, and a plurality of electrical pads for connecting the signal lines to the outside; preparing an FPC cable, the FPC cable having a plurality of conductors having bonding portions facing the pads, an upper protect film completely covering the upper surface of a conductor, and a lower protect film covering the lower surface of the conductor except for the bonding portion facing a pad; preparing a bonding apparatus adopting a hot pressure welding technique, the bonding apparatus having a stage for mounting the substrate on and a bonding tool for pressing the bonding portions of the conductors down on the pads of the substrate and heating the bonding portions attached to the pads; mounting the substrate on the stage of the bonding apparatus in order to combine the substrate with the FPC cable; arranging the FPC cable on the substrate so that the bonding portions of the conductors face the corresponding pads; and pressing at least two conductors down on the corresponding pads at a time using the bonding tool and heating the conductors using the bonding tool, to thereby bond the conductors to the pads.

According to an embodiment of the present invention, in the above methods, a tip for bringing the bonding portion of a conductor in contact with a corresponding pad is formed at both edges of the bonding tool.

Preferably, when the bonding tool bonds the conductors to the pads, the pads installed on one edge of the substrate are bonded symmetrically to the pads installed on the other edge of the substrate. Also, it is preferable that all of the pads on the substrate are bonded to the corresponding conductors at a time. Preferably, when the bonding tool bonds the conductors to the pads, it bends the FPC cable so that the bent portion of the FPC cable is placed at the rear of the substrate.

According to a preferred embodiment of the bonding method, bonding is performed with a bump interposed between the bonding portion of a conductor and a pad. Preferably, the lower protect film has an aperture facing a pad, and a bump is inserted into the aperture and electrically connects the bonding portion of a conductor to a corresponding pad.

The present invention, in a third aspect, provides a bonding apparatus for bonding the bonding portions of an FPC cable to the pads of a substrate in order to electrically connect the substrate for an ink jet print head, the substrate having a plurality of resistive heaters, a plurality of signal lines connected to the resistive heaters, and a plurality of electrical pads for connecting the signal lines to the outside, to the FPC cable having a plurality of conductors having bonding portions facing the pads, the bonding apparatus comprising a stage on which the substrate is mounted with the pads facing upward, and a bonding tool that moves up and down over the stage and has a bonding tip for pressing at least two bonding portions down on the corresponding pads and heating the bonding portions in contact with the pads to thereby bond the bonding portion to the pads using a hot pressure welding technique.

In the bonding apparatus, preferably, the bonding tool has a tip for bringing the bonding portions of the conductors of the FPC cable in contact with corresponding pads. More preferably, the tip protrudes from both edges of the bonding tool in order to bond opposite conductors to corresponding opposite pads among the pads formed on both edges of the substrate.

According to a preferred embodiment of the present invention for the above bonding apparatus, the bonding tool has a dam-shaped tip that covers all of the pads formed on the substrate. Also, the dam-shaped tip is symmetrically formed at both ends of the bonding tool such that the dam-shaped tip covers all of the pads formed along both edges of the substrate. Furthermore, the bonding tool has a protruding extension for bending the FPC cable beside the each edge of the substrate so that the FPC cable is placed from the upper surface level of the substrate to the position at the rear of the substrate.

The present invention, in a fourth aspect, provides an ink jet print head comprising a substrate having a plurality of resistive heaters, a plurality of signal lines connected to the resistive heaters, and a plurality of electrical pads for connecting the signal lines to an external circuit; and an FPC cable having a plurality of conductors and upper and lower films for protecting a conductor, wherein each of the conductors has a bonding portion to be bonded to a corresponding pad, wherein the conductors of the FPC cable are bonded to the corresponding pads of the substrate by hot pressure welding, and the bonding portion of a conductor that faces a corresponding pad is covered by the upper and lower films.

In the above-described ink jet print head, preferably, the FPC cable is bent such that its bent portion is placed at the rear of the substrate. It is also preferable that the upper and lower surfaces of a conductor is covered by the upper and lower films, and the lower film has a window formed directly over a corresponding pad to allow the conductor to contact the pad.

According to a preferred embodiment of the present invention for the ink jet print head, a conductive bump is interposed between the bonding portion of a conductor and a corresponding pad.

The present invention will become more apparent by describing in detail preferred embodiments thereof, by way of example only, with reference to the attached drawings; in which:
Figure 1 is a schematic diagram for illustrating a method of bonding a flexible printed circuit (FPC) cable for an ink jet print head using a conventional thermosonic welding technique;
Figure 2 is a flowchart for illustrating a method of bonding an FPC cable for an ink jet print head, according to the present invention;
Figure 3 is a schematic structure diagram of a bonding apparatus according to the present invention for explaining a method of bonding an FPC cable for an ink jet print head according to a first embodiment of the present invention;
Figure 4 is a plan view of an FPC cable used for an ink jet print head;
Figure 5 is a perspective view showing a bonding manner in which two pads at one time are bonded to an FPC cable by the FPC cable bonding method of Figure 3;
Figure 6 is a perspective view showing a method of bonding an FPC cable for an ink jet print head according to a second embodiment of the present invention;
Figure 7 is a schematic diagram for illustrating a method of bonding an FPC cable for an ink jet print head according to a third embodiment of the present invention;
Figure 8 is a perspective view of a bonding tool of a bonding apparatus according to the present invention for explaining a method of bonding an FPC cable for an ink jet print head according to a fourth embodiment of the present invention;
Figure 9 is a cross-sectional diagram for illustrating a method of bonding an FPC cable for an ink jet print head according to a fifth embodiment of the present invention;
Figure 10 is a partial cross-section of a substrate to which an FPC cable is bonded by the method of Figure 9;
Figure 11 is a partial cross-section of an ink jet print head cartridge on which the substrate to which an FPC cable is bonded by the method of Figure 9 is installed; and
Figure 12 is a cross-sectional view for illustrating a method of bonding an FPC cable for an ink jet print head according to a sixth embodiment of the present invention.

Hereinafter, an ink jet print head is not described but will be understood through the description of bonding methods and apparatuses according to the present invention.

Preferred embodiments of the present invention basically adopt hot pressure welding instead of thermosonic bonding, that is, thermosonic welding using local kinetic energy. In hot pressure welding, a fragile substrate is not subject to vibration impact, so that simultaneous bonding with respect to several pads is possible in contrast with thermosonic bonding.

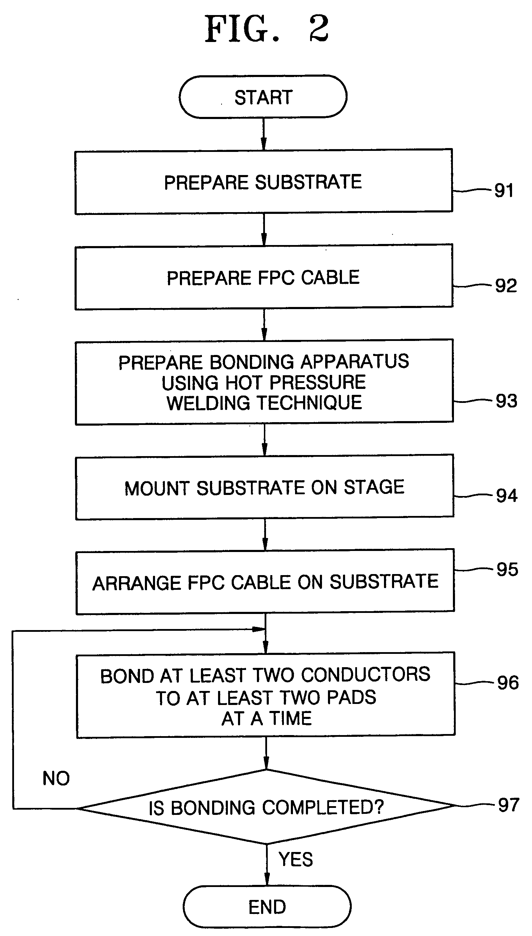

Figure 2 is a flowchart for illustrating a bonding method according to an embodiment of the present invention. Referring to Figure 2, first of all, a substrate for an ink jet print head is prepared, in step 91. Then, a flexible printed circuit (FPC) cable to be bonded to the substrate is prepared, in step 92. Next, a bonding apparatus for bonding the conductors of the FPC cable to the pads on the substrate using the hot pressure welding technique is prepared, in step 93. Thereafter, the substrate is mounted on the stage of the bonding apparatus, in step 94. Subsequently, the FPC cable is arranged on the substrate, in step 95. Next, the bonding tool of the bonding apparatus bonds the conductors of the FPC cable to the pads on the substrate using the hot pressure welding technique, in step 96. At this time, at least two conductors are bonded to at least two pads. This bonding repeats until all of the pads on the substrate are bonded to the corresponding conductors, in step 97. However, all of the pads can be simultaneously bonded to the corresponding conductors at a time.

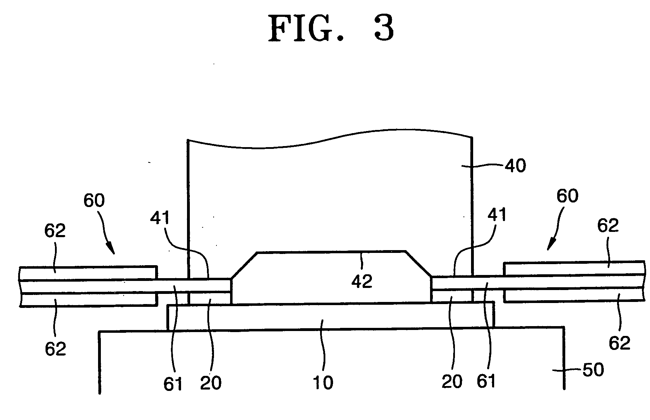

Figure 3 is a schematic structure diagram of a bonding apparatus according to an embodiment of the present invention in which a bonding tool bonds an FPC cable to a substrate in a bonding method according to a first embodiment of the present invention. Referring to Figure 3, a substrate 10 to be bonded is mounted on a stage 50 of a bonding apparatus adopting a hot pressure welding technique. The substrate 10 includes a plurality of resistive heaters, a plurality of signal lines connected to the heaters, and a plurality of electric pads for connecting the signal lines to an external circuit. Figure 3 shows only the electric pads 20.

The conductors 61 of a FPC cable 60 are placed on the pads 20 and depressed by the tip 41 of a bonding tool 40. The conductors 61 of the FPC cable 60 are protected by upper and lower insulative protect films 62.

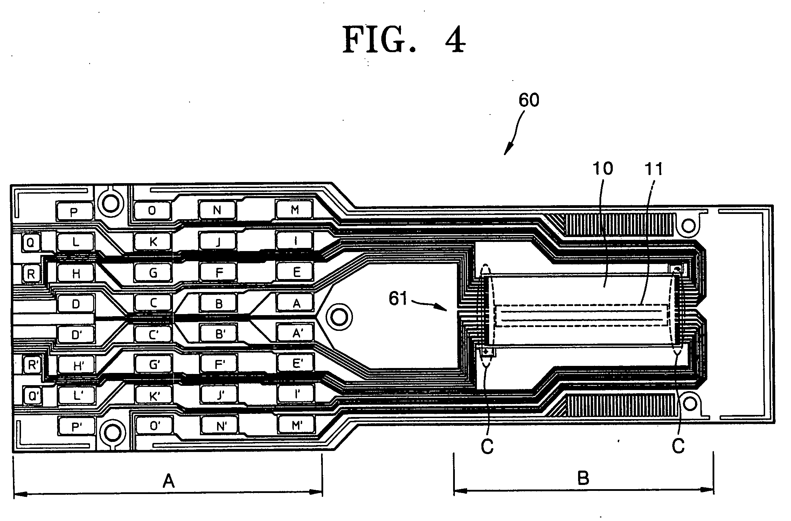

Figure 4 is a plan view of the FPC cable 60. The FPC cable 60 is largely divided into a pad area A having a plurality of contact pads (indicated by alphabets), which contact the contact terminals (not shown) provided in the head transfer mechanism of a printer, and a bonding area B where the conductors 61 bonded to the pads 20 of the substrate 10 of an inkjet print head are arranged. Reference numeral 11 denotes a nozzle area formed on the substrate 10. In the FPC cable 60 of Figure 3, the bonding portions (front ends) of the conductors 61 are arranged in areas C corresponding to the short edges of the substrate 10.

Referring back to Figure 3, the first embodiment shown in Figure 3 is characterized in that the bonding portions of conductors 61 are bonded to opposite pads 20 installed on opposite edges of the substrate 10. In this embodiment, two conductors 61 are bonded to two opposite pads 20 installed on both ends of the substrate 10 at a time. Bonding energy is created by heat or pressure. The FPC cable 60 is arranged on the substrate 10 mounted on the stage 50, such that it is placed at a bonding location as shown in Figure 4. Next, the bonding tool 40 heated to a predetermined temperature performs hot pressure welding by depressing the conductors 61 down on the pads 20 on the substrate 10 placed directly under the conductors 61. At this time, heat also comes out of the stage 50, and the substrate 10 and the pads 20 may be heated. This hot pressure wielding is achieved within a very short period of time, in which the bottoms of the bonding portions of the conductors 61 and the pads are locally melted and joined together. In Figure 3, reference numeral 42 denotes a recess formed to protect elements such as heaters formed on a substrate.

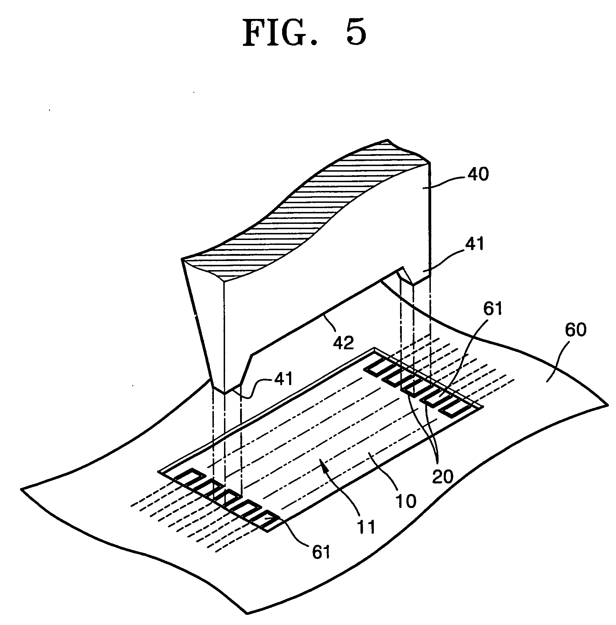

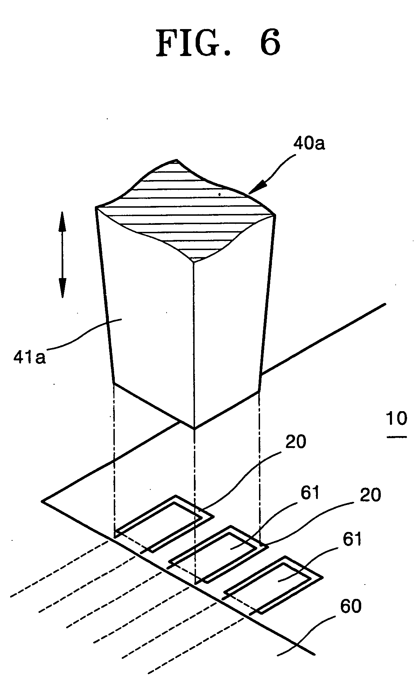

In the first embodiment as shown in Figure 3, the conductors 61 are bonded to opposite pads installed on opposite ends of the substrate 10. However, as shown in Figure 6, two adjacent pads 20 installed on one edge of a substrate may be bonded to corresponding conductors 61 by a bonding tool 40a designed for this style of bonding. The method of Figure 6 corresponds to a second embodiment of the present invention. The bonding tools 40 and 40a are movable over the surface of the stage 50 as in general bonding apparatuses, so that the other pads installed on the substrate can also be bonded. A bonding method according to preferred embodiments of the present invention is characterized in that at least two pads are bonded to corresponding conductors at a time and that any at least two pads can be selected. However, it is preferable that opposite pads on both ends of the substrate 10 are selected and bonded, as shown in Figures 3 and 5.

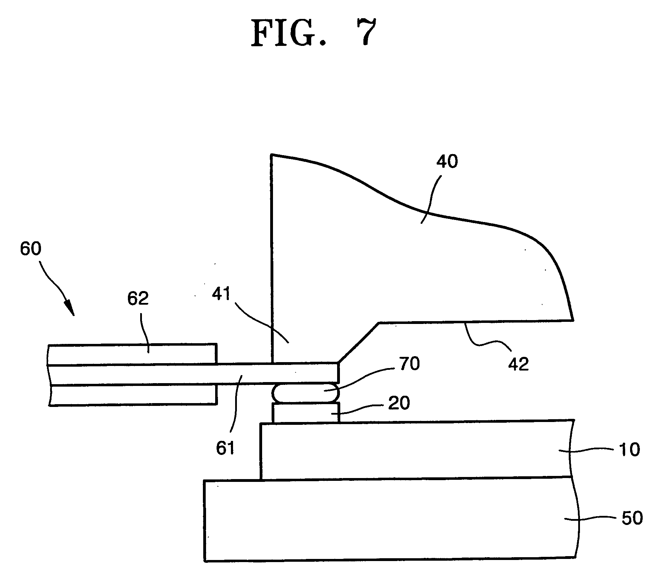

In order to achieve more effective bonding, it is preferable to install a conductive bump 70 between the pad 20 and the conductor 61, as shown in Figure 7. The method of Figure 7 corresponds to a third embodiment of the present invention. The bump 70 is made of lead, gold, or other conductive materials. The type of material of such a bump does not restrict the technical scope of the present invention. The bump 70 installed on the pad 20 is formed by a general method, so the formation method will not be described.

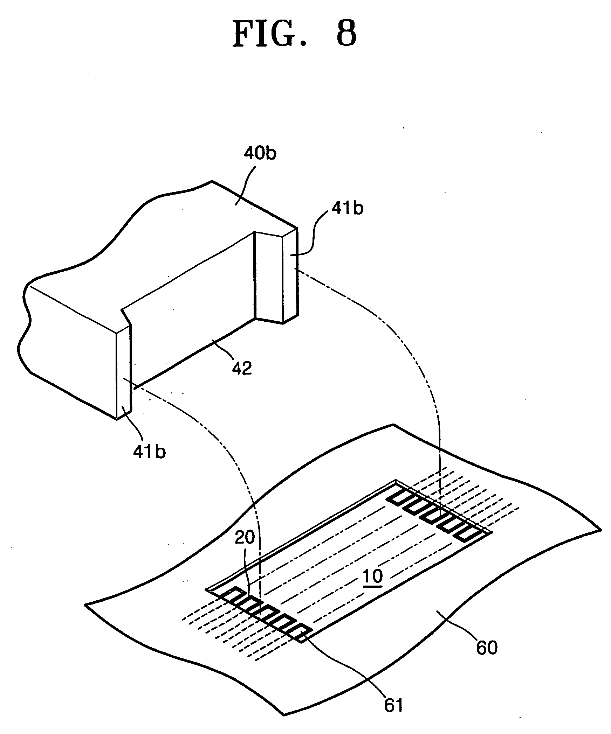

In a fourth embodiment of the present invention as shown in Figure 8, all of the pads 20 on the substrate 10 are bonded to corresponding conductors 61 at a time. That is, this bonding corresponds to gang bonding. To do this, a bonding tool 40b has a size that covers all of the pads 20 on the substrate 10, and two opposite tips 41b are formed on the bottom of the bonding tool 40b in dam shapes extending along both ends of a substrate. That is, the dam-shaped tips 41b bond all of the pads arranged on opposite edges of the substrate10 to corresponding conductors 61 using heat and pressure.

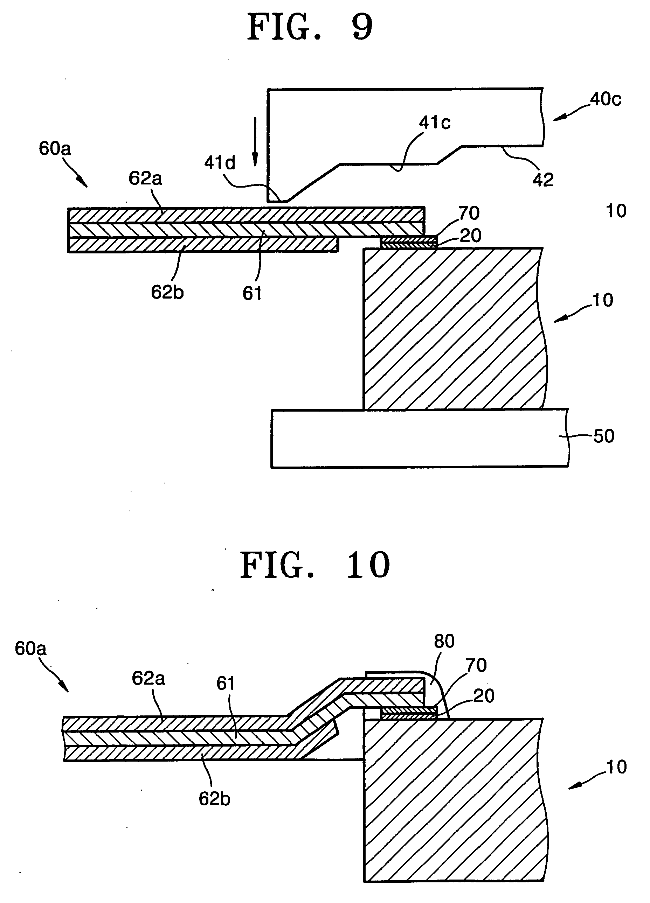

In a bonding method according to preferred embodiments of the present invention, not only the bonding style but also the shape of an FPC cable is properly changed, as shown in Figure 9. Referring to Figure 9, the substrate 10 is mounted on the stage 50. A pad is installed on the edge of the substrate 10, and the bump 70 is then installed on the pad 20. An FPC cable 60a includes upper and lower protect films 62a and 62b formed on the upper and lower sides of a conductor 61, respectively. In a fifth embodiment of the present invention as shown in Figure 9, the FPC cable 60a has the upper protect film 62a that completely covers the conductor 61. However, the FPC cable 60 can be applied to the fifth embodiment of Figure 9.

The bonding apparatus of Figure 9 is characterized in that a tip 41c of a bonding tool 40c has a protrusion 41d extending to the outside of the substrate 10. Since the protrusion 41d protrudes lower than the tip 41c, the FPC cable 60a is bended beside the substrate 10 upon bonding. Since the bending is permanent, even after the bonding is completed, the bended portion of the FPC cable 60a lasts permanently in a shape as shown in Figure 10. In this way, the bonding for electrically connecting the FPC cable 60a to the substrate 10 is completed. As shown in Figure 10, exposed portions of the conductor 61 and pad 20 are encapsulated by resin, forming an encapsulator 80.

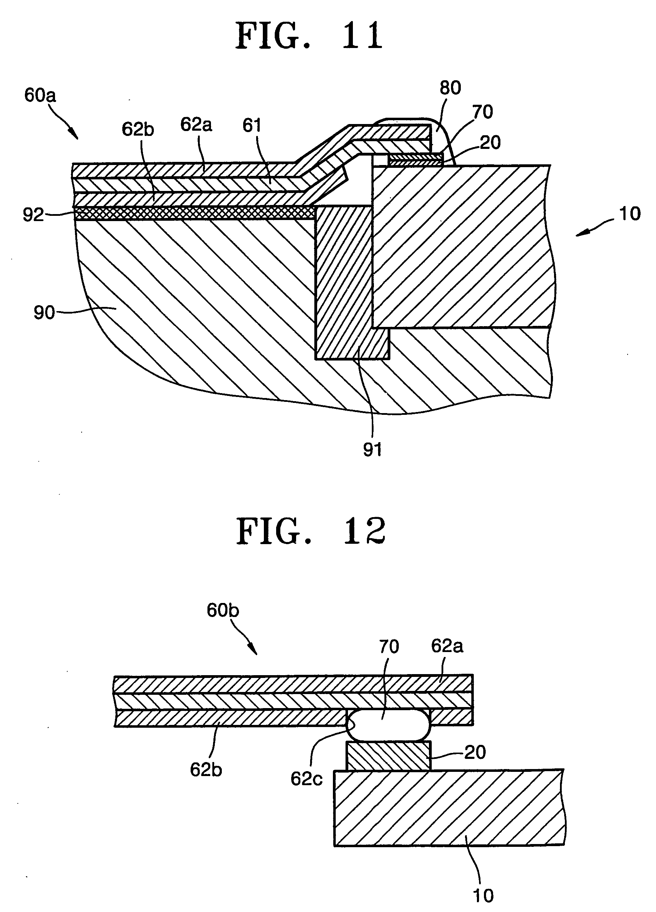

When the FPC cable 60a bended at both ends of the substrate 10 is installed on a cartridge 90 for an ink jet printer, as shown in Figure 11, it is closely attached to the upper surface of the cartridge 90. However, if the FPC cable 60a is not bent at both ends of the substrate 10, it is combined with a cartridge in a state of being positioned relatively high beside the substrate 10. This may cause a difficulty in wiping a nozzle area.

In Figure 11, reference numeral 91 denotes resin, such as epoxy, for attaching the substrate 10 to an ink reservoir and preventing ink leakage, and reference numeral 92 denotes a double-sticky tape for attaching the cable 60a to the cartridge 90. Since the upper surface of the conductor 61 is covered by the protect film 62a, 62b, the encapsulator 80 is formed of a small amount of resin supplied to only the exposed portions of the conductor 61 and the pad 20. Consequently, the encapsulator 80 is small and especially is not high from the substrate. Hence, the interval between the substrate 10 and a medium, such as paper, depending on an encapsulator can be significantly narrowed. In the prior art, since the upper surface of a conductor is exposed, much resin enough to cover the exposed portion must be supplied, so that a high encapsulator is created. This leads to a large interval between a medium to be printed on and the surface of the substrate 10.

The FPC cable 60a capable of creating a low encapsulator can be applied to the previous embodiments.

Figure 12 shows the structure of an FPC cable 60b capable of being applied to the previous embodiments. In the FPC cable 60b, which is a transformation of the FPC cable 60a shown in Figures 9 through 11, the bonding portion of the conductor 61 is covered by upper and lower protect films 62a and 62b, having an aperture 62c formed in the portion facing the pad 20. The FPC cable 60b is electrically connected to the substrate 10 via the aperture 62c by bonding the conductor 61 to the pad 20. In a sixth embodiment of the present invention, as shown in Figure 12, the bump 70 is installed in the aperture 62c in order to help more effective bonding between the pad 20 and the conductor 61.

In the above-described preferred embodiments of the present invention, an electrical defect due to pad peel-off phenomenon, which is created by an conventional tape automated bonding (TAB) method in which the conductors of an FPC cable are bonded to the pads on a substrate in a manner where one conductor is bonded to a pad at a time, is removed to increase the reliability of bonding. The reliability is maximized by bonding at least two pads at a time, more preferably, by bonding all of the pads on a substrate at a time, which is called gang bonding. Also, the interval between the substrate and a medium is narrowed, reducing the interlaced distance of droplet discharged from the substrate. Thus, more stable printing quality with higher density is provided.

While this invention has been particularly shown and described with reference to preferred embodiments thereof, it will be understood by those skilled in the art that various changes in form and details may be made therein without departing from the spirit and scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method of bonding a flexible printed circuit (FPC) for an ink jet print head, the method comprising:
preparing (91) a substrate (10) for an ink jet print head, the substrate (10) having a plurality of resistive heaters, a plurality of signal lines connected to the resistive heaters, and a plurality of electrical pads (20) for connecting the signal lines to the outside;
preparing (92) an FPC cable (60) having a plurality of conductors (61) having bonding portions, the conductors corresponding to the pads (20);
preparing (93) a bonding apparatus (40, 50) adopting a hot pressure welding technique, the bonding apparatus having a stage (50) for mounting the substrate (10) on and a bonding tool (40) for pressing the bonding portions of the conductors down on the pads (20) of the substrate and heating the bonding portions attached to the pads (20);
mounting (94) the substrate (10) on the stage (50) of the bonding apparatus (40, 50) in order to combine the substrate (10) with the FPC cable (60);
arranging (95) the FPC cable (60) on the substrate (10) so that the bonding portions of the conductors (61) face the corresponding pads (20); and
pressing (96) at least two conductors (61) down on the corresponding pads (20) at a time using the bonding tool (40, 50) and heating the conductors (61) using the bonding tool (40, 50), to thereby bond the conductors (61) to the pads (20).

2. The method of claim 1, wherein a tip (41) for bringing the bonding portion of a conductor in contact with a corresponding pad is formed at both edges of the bonding tool.

3. The method of claim 2, wherein, when the bonding tool (40) bonds the conductors (61) to the pads (20), the pads (20) installed on one edge of the substrate (10) are bonded symmetrically to the pads (20) installed on the other edge of the substrate (10).

4. The method of any preceding claim, wherein all of the pads (20) on the substrate (10) are bonded to the corresponding conductors (61) at a time.

5. The method of any preceding claim, wherein, when the bonding tool (40, 50) bonds the conductors (61) to the pads (20), it bends the FPC cable (60) so that the bent portion of the FPC cable (60) is placed at the rear of the substrate (10).

6. The method of any one of claims 1 through 4, wherein bonding is performed with a bump (70) interposed between the bonding portion (40) of a conductor and a corresponding pad (20).

7. A method of bonding a flexible printed circuit (FPC) for an ink jet print head, the method comprising:
preparing (91) a substrate (10) for an ink jet print head, the substrate (10) having a plurality of resistive heaters, a plurality of signal lines connected to the resistive heaters, and a plurality of electrical pads (20) for connecting the signal lines to the outside;
preparing (92) an FPC cable (60), the FPC cable having a plurality of conductors (61) having bonding portions facing the pads (20), an upper protect film (62a) completely covering the upper surface of a conductor (61), and a lower protect film (62b) covering the lower surface of the conductor (61) except for the bonding portion facing a pad (20);
preparing (93) a bonding apparatus (40, 50) adopting a hot pressure welding technique, the bonding apparatus (40, 50) having a stage (50) for mounting the substrate on and a bonding tool (40) for pressing the bonding portions of the conductors (61) down on the pads (20) of the substrate (10) and heating the bonding portions attached to the pads (20) ;
mounting (94) the substrate (10) on the stage (50) of the bonding apparatus (40, 50) in order to combine the substrate (10) with the FPC cable (60);
arranging (95) the FPC cable (60) on the substrate (10) so that the bonding portions of the conductors (61) face the corresponding pads (20); and
pressing (96) at least two conductors (61) down on the corresponding pads (20) at a time using the bonding tool (40, 50) and heating the conductors (61) using the bonding tool (40, 50), to thereby bond the conductors (61) to the pads (20).

8. The method of claim 7, wherein a tip (41) for bringing the bonding portion of a conductor (61) in contact with a corresponding pad (20) is formed at both edges of the bonding tool (40, 50).

9. The method of claim 8, wherein, when the bonding tool (40, 50) bonds the conductors (61) to the pads (20), the pads (20) installed on one edge of the substrate (10) are bonded symmetrically to the pads (20) installed on the other edge of the substrate (10).

10. The method of any one of claims 7-9, wherein all of the pads (20) on the substrate (10) are bonded to the corresponding conductors (61) at a time.

11. The method of any one of claims 7 through 10, wherein, when the bonding tool (40, 50) bonds the conductors (61) to the pads (20), it bends the FPC cable (60) beside the edges of the substrate (10) so that the bent portion of the FPC cable (60) is placed at the rear of the substrate (10).

12. The method of any one of claims 7 through 10, wherein bonding is performed with a bump (70) interposed between the bonding portion of a conductor (61) and a pad (20).

13. The method of any one of claims 7 through 10, wherein the lower protect film (62b) has an aperture facing a pad (20).

14. The method of claim 13, wherein a bump (70) is inserted into the aperture and electrically connects the bonding portion of a conductor (61) to a corresponding pad (20).

15. A bonding apparatus (40, 50) for bonding the bonding portions of an FPC cable (60) to the pads (20) of a substrate (10) in order to electrically connect the substrate (10) for an ink jet print head, the substrate (10) having a plurality of resistive heaters, a plurality of signal lines connected to the resistive heaters, and a plurality of electrical pads (20) for connecting the signal lines to the outside, to the FPC cable (60) having a plurality of conductors (61) having bonding portions facing the pads (20), the bonding apparatus (40, 50) comprising:
a stage (50) on which the substrate (10) is mounted with the pads (20) facing upward; and
a bonding tool (40) that moves up and down over the stage (50) and has a bonding tip (41) for pressing at least two bonding portions down on the corresponding pads (20) and heating the bonding portions in contact with the pads (30) to thereby bond the bonding portion to the pads (20) using a hot pressure welding technique.

16. The bonding apparatus (40, 50) of claim 15, wherein the bonding tool (40) has a tip (41) for bringing the bonding portions of the conductors (61) of the FPC cable (60) in contact with corresponding pads (20).

17. The bonding apparatus (40, 50) of claim 16, wherein the tip (41) protrudes from both edges of the bonding tool (40) in order to bond opposite conductors (61) to corresponding opposite pads (20) among the pads (20) formed on both edges of the substrate (10).

18. The bonding apparatus (40, 50) of any one of claims 15-17, wherein the bonding tool (40) has a dam-shaped tip (41b) that covers all of the pads (20) formed on the substrate (10).

19. The bonding apparatus (40, 50) of claim 18, wherein the dam-shaped tip (41b) is symmetrically formed at both ends of the bonding tool (40) such that the dam-shaped tip (41b) covers all of the pads (20) formed along both edges of the substrate (10).

20. The bonding apparatus (40, 50) of any one of claims 15 through 19, wherein the bonding tool (40) has a protruding extension for bending the FPC cable (66) beside the each edge of the substrate (10) so that the FPC cable (60) is placed from the upper surface level of the substrate (10) to the position at the rear of the substrate.

21. An ink jet print head comprising:
a substrate (10) having a plurality of resistive heaters, a plurality of signal lines connected to the resistive heaters, and a plurality of electrical pads (20) for connecting the signal lines to an external circuit; and
an FPC cable (60) having a plurality of conductors (61) and upper (62a) and lower (62b) films for protecting a conductor (61), wherein each of the conductors (61) has a bonding portion to be bonded to a corresponding pad (20), wherein the conductors (61) of the FPC cable (10) are bonded to the corresponding pads (20) of the substrate (10) by hot pressure welding, and the bonding portion of a conductor (61) that faces a corresponding pad (20) is covered by the upper and lower films (62a, 62b).

22. The ink jet print head of claim 21, wherein the FPC cable (60) is bent such that its bent portion is placed at the rear of the substrate (10).

23. The ink jet print head of claim 21 or 22, wherein the upper and lower surfaces of a conductor (61) is covered by the upper and lower films (62a, 62b), and the lower film (62b) has a window formed directly over a corresponding pad (20) to allow the conductor (61) to contact the pad (20).

24. The ink jet print head of any one of claims 21-23, wherein a conductive bump (70) is interposed between the bonding portion of a conductor (61) and a corresponding pad (20).
